# EUROPÄISCHE PATENTSCHRIFT

(11) **EP 3 355 591 B1**
(45) Veröffentlichungstag und Bekanntmachung des Hinweises auf die Patenterteilung: **04.12.2019**
(21) Anmeldenummer: 17207541.8
(22) Anmeldetag: 15.12.2017
(51) Int. Cl.: H04R 25/00

(54) **HÖRGERÄT UMFASSEND EINE MIKROFONEINHEIT MIT EINEM GEHÄUSE**
HEARING AID COMPRISING A MICROPHONE UNIT WITH A HOUSING
PROTHÈSE AUDITIVE AVEC UNE UNITÉ DE MICROPHONE DOTÉE D'UN BOITIER

(30) Priorität: 30.01.2017 DE 102017201465
(43) Veröffentlichungstag der Anmeldung: 01.08.2018
(73) Patentinhaber: Sivantos Pte. Ltd., Singapore 539775 (SG)
(72) Erfinder: NÄTHER, Thomas, 32657 Lemgo (DE); STEFFEN, Marco, 32120 Hiddenhausen (DE)
(74) Vertreter: FDST Patentanwälte

(56) Entgegenhaltungen:
- US-A1- 2009 161 886
- US-B2- 7 254 247

## Beschreibung

Die Erfindung betrifft ein Hörgerät umfassend eine Mikrofoneinheit mit einem Gehäuse, welches eine erste Hauptfläche und eine zweite Hauptfläche aufweist, die einander gegenüberliegen, und welches einen Innenraum umschließt, der einen Resonanzraum umfasst.

In einem Hörgerät, insbesondere einem Hörhilfegerät, wird üblicherweise von einem Mikrofon ein Umgebungsschall in ein Audiosignal umgewandelt, welches in einer Signalverarbeitungseinheit weiter verarbeitet und dabei insbesondere frequenzbandabhängig verstärkt wird, und das hieraus resultierende Ausgangssignal von einem Lautsprecher in ein Ausgangsschallsignal umgewandelt. Das Ausgangsschallsignal wird dann dem Gehör eines Benutzers des Hörgerätes zugeführt. Je nach den audiologischen und anatomischen Anforderungen des Benutzers, und um das einzelne Hörgerät bei Tragen am Ohr für Dritte so unauffällig wie möglich auszugestalten, gibt es auf dem Markt Bauformen für Hörgeräte, bei denen wenigstens ein Teil während Tragens Gebrauchs im Gehörgangseingangstrichter oder im Gehörgang des Benutzers liegt, wie beispielsweise die ITE-Bauform, die ITC-Bauform, oder die CIC- bzw. IIC-Bauform ("in the ear", "in the canal", "completely in the canal", "invisible in the canal").

Durch die typischen anatomischen Gegebenheiten werden hierbei den möglichen Abmessungen der einzelnen Bauformen enge Grenzen gesetzt. Dies stellt an die Entwicklung des Hörgerätes als solches sowie an die platzoptimierte Entwicklung der einzelnen Komponenten hohe Anforderungen. Im Hörgerät sind neben der eingangs genannten Komponenten Mikrofon, Signalverarbeitungseinheit, und Lautsprecher zumindest noch eine Batterie zur Leistungsversorgung sowie meist noch weitere Komponenten, beispielsweise eine Antenne zur externen Datenübertragung anzuordnen.

In Hörgeräten werden derzeit häufig Mikrofone mit einem Mikro-Elektromechanischen System (MEMS, "micro electro mechanical system") verwendet. Bei einem derartigen MEMS-Mikrofon sind die eigentlichen signalerzeugenden Komponenten zusammen mit Elektronikkomponenten zur Vorverarbeitung des erzeugten Signals in einem Gehäuse verbaut, welches eine Schalleintrittsöffnung aufweist, und dessen Innenraum somit als Resonanzraum dient. Die Elektronickomponenten sind dabei zusammen mit den eigentlichen signalerzeugenden Komponenten oftmals auf einer gemeinsamen Leiterplatte verlötet, welche auch eine Deckel- oder Bodenfläche des Gehäuses bildet. Bei besonders kleinen Bauformen für Hörgeräte, wie beispielsweise der IIC-Bauform werden die Abmessungen, also sowohl die Größe als auch die Form des Hörgerätes, im Wesentlichen durch die Batterie mit vorgegeben, welche, um einen ordentlichen Betrieb zu gewährleisten, nicht beliebig verkleinert werden kann. Die Anordnung eines MEMS-Mikrofons mit marktüblichen Dimensionen in der unmittelbaren Umgebung einer eben solchen Batterie lässt hierbei noch Optimierungsspielraum für die endgültige Abmessung des Hörgerätes offen.

In der US 2009/0161886 A1 ist eine Mikrofoneinheit offenbart, deren Gehäuse je nach Ausgestaltung an einer Seite eine konvexe Wölbung oder eine konkave Einbuchtung aufweist. Die Mikrofoneinheit ist dabei für eine Spracherkennung in einer Fernbedienung oder für einen Einsatz in einem Mobil- oder Festnetz-Telefon vorgesehen, wobei die Wölbung bzw. Einbuchtung der Mikrofoneinheit an eine entsprechende Formung im Gehäuse der Fernbedienung bzw. des Telefons angepasst ist.

Die US 7,254,247 B2 nennt ein Hörgerät mit einer zylinderförmigen Batterie, welche im Wesentlichen die Form des Hörgerätes bestimmt. Entlang der Mantelfläche der Batterie sind in das Gehäuse des Hörgerätes Taschen angeordnet, in welchen Mikrofone eingesetzt sind.

Der Erfindung liegt daher die Aufgabe zugrunde, ein Hörgerät anzugeben, in welchem möglichst platzsparend eine Mikrofoneinheit verbaut werden kann.

Die genannte Aufgabe wird erfindungsgemäß gelöst durch ein Hörgerät, umfassend eine im Wesentlichen zylinderförmige Batterie und eine Mikrofoneinheit mit einem Gehäuse, welches eine erste Hauptfläche und eine zweite Hauptfläche aufweist, die einander gegenüberliegen, und einen Innenraum umschließt, der einen Resonanzraum umfasst. Hierbei ist vorgesehen, dass die erste Hauptfläche eine konkave Einbuchtung zum Innenraum hin aufweist, und dass die konkave Einbuchtung in der ersten Hauptfläche der Mikrofoneinheit derart an den Radius der Batterie angepasst ist, dass die Mikrofoneinheit entlang eines Abschnitts der Mantelfläche der Batterie angeordnet ist. Vorteilhafte und teils für sich erfinderische Ausgestaltungen sind Gegenstand der Unteransprüche und der nachfolgenden Beschreibung.

Die Batterie kann dabei insbesondere mit weiteren Komponenten, wie beispielweise einem Spannungswandler, zu einer Batterieeinheit zusammengefasst sein, um eine von der Batterie ausgegebene Versorgungsspannung auf eine Betriebsspannung des Hörgerätes zu konvertieren, wobei die zusätzlichen Komponenten der Batterieeinheit insbesondere an den Stirnflächen der Batterie angeordnet sind, so dass auch für die Batterieeinheit die im Wesentlichen zylindrische Form, welche durch die Batterie vorgegeben wird, erhalten bleibt.

Die erste Hauptfläche und die zweite Hauptfläche sind dabei bevorzugt jeweils begrenzt durch kantenartige Schnitte oder durch gegebenenfalls abgerundete Kanten, an welche sich jeweils eine Seitenfläche des Gehäuses anschließt, wobei ein Krümmungsradius einer Abrundung gegenüber der Abmessung der Hauptfläche vernachlässigbar ist. Insbesondere stellen hierbei die erste Hauptfläche und die zweite Hauptfläche die flächenmäßig größten Außenflächen des Gehäuses dar. Bevorzugt wird durch das Gehäuse der Innenraum vollständig, gegebenenfalls bis auf eine Anzahl an Schalleintrittsöffnungen, umschlossen. Der Resonanzraum wird insbesondere gebildet durch den vollständigen Innenraum abzüglich von gegebenenfalls im Innenraum verbauten Komponenten der Mikrofoneinheit, oder durch einen Teil des unverbauten Innenraumes, wenn beispielsweise der Innenraum eine entsprechende Trennwand aufweist. Bevorzugt ist im Innenraum wenigstens eine signalerzeugende Komponente angeordnet, welche dazu eingerichtet ist, eine Schalldruck- und/oder Luftdruckänderung in ein elektrisches Signal umzuwandeln. Weiter bevorzugt sind im Innenraum zusätzlich weitere Elektronickomponenten zur Vorverarbeitung eines derart erzeugten elektrischen Signals verbaut, insbesondere zur Vorverstärkung und/oder Dynamik-Kompression und/oder Analog-Digital-Wandlung, um durch die Mikrofoneinheit ein möglichst weiterverarbeitungsfähiges Audiosignal auszugeben, welches insbesondere einen gewissen Mindest-Signalpegel erreicht.

Die konkave Einbuchtung zum Innenraum hin kann sich über die gesamte erste Hauptfläche oder auch nur über einen vorzugsweise wesentlichen Flächenabschnitt, bevorzugt über wenigstens die Hälfte einer Flächenrichtung, erstrecken. Die konkave Einbuchtung kann hierbei auch flächenabschnittsweise eben sein, vergleichbar einem Paravent. Unter einer konkaven Einbuchtung zum Innenraum hin ist hierbei generell zu verstehen, dass eine parametrisierbare Menge an Strecken existiert, wobei für jede der Strecken die beiden Endpunkte jeweils im Bereich von einander gegenüberliegenden Enden des die konkave Einbuchtung betreffenden Flächenstückes der ersten Hauptfläche im Innenraum liegen, und die Strecke die erste Hauptfläche zwei Mal schneidet. Mit anderen Worten bedeutet dies, dass das Gehäuse durch die konkave Einbuchtung ein geringeres umschlossenes Volumen aufweist, als das Volumen, welches ein Gehäuse mit einer ersten Hauptfläche ohne jegliche konkave Einbuchtung aufweisen würde. Gegenüber einem derartigen Gehäuse, in welchem also sämtliche Strecken, deren Endpunkte im Innenraum an der ersten Hauptfläche liegen, auch durchweg im Innenraum verlaufen, "fehlt" dem erfindungsgemäßen Gehäuse mit der konkaven Einbuchtung der ersten Hauptfläche im Bereich dieser Hauptfläche ein Volumenstück.

Die konkave Einbuchtung kann vorzugsweise in ihren Abmessungen, also insbesondere im Grad der Krümmung und in der Eindringtiefe in den Innenraum, auf die Form eines anderen Baugliedes der übergeordneten Vorrichtung abgestimmt sein, in welcher die Mikrofoneinheit zum Einbau vorgesehen ist, also insbesondere an ein Bauglied in einem Hörgerät. Hierdurch greift das Bauglied in die konkave Einbuchtung der Mikrofoneinheit ein, anstatt dass die Mikrofoneinheit in Folge der Form des Baugliedes von diesem weiter beabstandet zu verbauen wäre. Somit kann die übergeordnete Vorrichtung, also insbesondere ein Hörgerät, kompakter gebaut werden als bei einem Einbau einer vergleichbaren Mikrofoneinheit ohne die entsprechende konkave Einbuchtung.

Günstigerweise erstreckt sich hierbei die konkave Einbuchtung zum Innenraum hin über die ganze Länge der ersten Hauptfläche. Mit anderen Worten ist somit die gesamte Hauptfläche konkav, also zum Innenraum hin gekrümmt bzw. gewölbt. Bevorzug erfolgt dabei die konkave Einbuchtung entlang der längeren Flächenseite, wenn die erste Hauptfläche eine im Wesentlichen rechteckförmige Draufsicht aufweist. Die Einbuchtung kann hierbei als eine glatte Krümmung der ersten Hauptfläche ausgebildet sein, oder aber auch einzelne ebene Flächenabschnitte umfassen. Die konkave Einbuchtung kann derart erfolgen, dass in einer Flächenrichtung jeweils Geraden in die erste Hauptfläche legbar sind, und somit entlang dieser Flächenrichtung die erste Hauptfläche weder gekrümmt noch anderweitig eingebuchtet ist. Alternativ dazu kann die konkave Einbuchtung insbesondere auch derart erfolgen, dass bezüglich jeder der Seitenflächen des Gehäuses eine Flächennormale existiert, welche die Einbuchtung zwei Mal schneidet. Ein Erstrecken der konkaven Einbuchtung über die Gesamtlänge der ersten Hauptfläche ermöglicht es, die Mikrofoneinheit vollständig, also in ihrer gesamten Abmessung, an ein anderes Bauteil der übergeordneten Vorrichtung anzupassen, wodurch ein besonders kompakter Einbau ermöglicht wird.

Zweckmäßigerweise weist die zweite Hauptfläche eine konvexe Ausbuchtung auf. Die konvexe Ausbuchtung kann sich dabei über die gesamte zweite Hauptfläche oder auch nur über einen vorzugsweise wesentlichen Flächenabschnitt, bevorzugt über wenigstens die Hälfte einer Flächenrichtung, erstrecken. Die konkave Ausbuchtung kann hierbei auch flächenabschnittsweise eben sein, vergleichbar einem Paravent. Unter einer konvexen Ausbuchtung ist hierbei generell zu verstehen, dass eine parametrisierbare Menge an Strecken existiert, wobei für jede der Strecken die beiden Endpunkte jeweils dem Innenraum zugewandt am die konvexe Ausbuchtung betreffenden Flächenabschnitt der zweiten Hauptfläche liegen, und die Strecke vollständig durch den Innenraum verläuft. Mit anderen Worten bedeutet dies, dass das Gehäuse durch die konvexe Ausbuchtung ein größeres umschlossenes Volumen aufweist als das Volumen, welches ein Gehäuse mit einer ersten Hauptfläche ohne jegliche konvexe Ausbuchtung aufweisen würde. Gegenüber einem derartigen Gehäuse ist dem erfindungsgemäßen Gehäuse mit der konvexen Ausbuchtung der ersten Hauptfläche im Bereich dieser Hauptfläche ein nach außen, also vom Innenraum weg gewölbtes Volumenstück hinzugefügt.

Insbesondere sind die erste Hauptfläche und die zweite Hauptfläche lokal parallel zueinander angeordnet, d.h., dass sie bezüglich der lokalen Flächennormalen einen konstanten Abstand zueinander aufweist. Dies ist beispielsweise bei einer Ausgestaltung der ersten und zweiten Hauptfläche als jeweilige Mantelabschnitte zweier koaxialer Zylinder der Fall. Eine derartige Ausgestaltung ist insbesondere von Vorteil, wenn das Bauglied, welches beim Einbau in die übergeordnete Vorrichtung in die konkave Einrichtung der Mikrofoneinheit eingreift, eine Dreh- oder Rotationssymmetrie aufweist. Alternativ dazu kann die erste Hauptfläche parallel zur zweiten Hauptfläche verschoben sein. Eine derartige Beabstandung lässt sich in der Fertigung ohne einen erheblichen Mehraufwand überwachen, was im Fertigungsprozess die Kosten begrenzt. Eine konvexe Ausbuchtung an der zweiten Hauptfläche sorgt dafür, dass zusätzlich zum Eingreifen des Baugliedes in die konkave Einbuchtung der ersten Hauptfläche die gesamte Mikrofoneinheit in ihrer Form an die Form des Bauglieds angepasst werden kann, was eine noch kompaktere Bauweise ermöglicht.

Vorteilhafterweise umfasst die zweite Hauptfläche eine Anzahl an Schalleintrittsöffnungen. Unter einer Schalleintrittsöffnung ist dabei generell eine Öffnung zu verstehen, welche infolge ihrer Größe und Anordnung dazu geeignet ist, Schallwellen, insbesondere Schallwellen im menschlichen Hörspektrum, von außerhalb der Mikrofoneinheit in den Innenraum zu führen, sodass dabei Verfälschungseffekte wie Absorption oder Beugung mit Interferenzen vernachlässigbar bleiben. Bevorzugt ist hierzu die oder jede Schalleintrittsöffnung als einzelne Bohrung in der zweiten Hauptfläche ausgestaltet. Hierbei kann insbesondere den Schallwellen auf dem durch die Schalleintrittsöffnung vorgegebenen Schallweg in den Innenraum des Gehäuses durch Komponenten, welche innerhalb des Gehäuses angeordnet sind, noch eine weitere Struktur aufgeprägt werden. Durch eine Schalleintrittsöffnung in der zweiten Hauptfläche kann Umgebungsschall in den Innenraum der Mikrofoneinheit gelangen, und dort mittels entsprechender signalerzeugender Komponenten in ein elektrisches Signal umgewandelt werden. Hierdurch können infolge der Schutzwirkung des Gehäuses für die signalerzeugenden Komponenten diese besonders filigran dimensioniert werden, so dass die Mikrofoneinheit besonders kompakt gebaut werden kann.

Bevorzugt umfasst die erste Hauptfläche und/oder die zweite Hauptfläche eine Leiterplatte. Insbesondere bedeutet dies, dass die erste Hauptfläche und/oder die zweite Hauptfläche des Gehäuses durch die betreffende Leiterplatte selbst gebildet wird. Alternativ dazu kann das Gehäuse derart ausgestaltet sein, dass an einer Gehäuseinnenwand an der ersten Hauptfläche und/oder der zweiten Hauptfläche die betreffende Leiterplatte angeordnet ist. Insbesondere sind auf der bzw. auf wenigstens einer Leiterplatte signalerzeugende Komponenten zur Erzeugung eines elektrischen Signals aus lokalen Schall- bzw. Luftdruckunterschieden angeordnet, und bevorzugt mit der Leiterplatte elektrisch kontaktiert, beispielsweise durch Verlöten. Im Fall, dass die erste Hauptfläche eine Leiterplatte umfasst, verläuft diese insbesondere entlang der konvexen Ausbuchtung. Für den Fall, dass die zweite Hauptfläche eine Leiterplatte umfasst, verläuft diese insbesondere entlang der konvexen Einbuchtung zum Innenraum hin. Mit anderen Worten ist die Leiterplatte in beiden Fällen nicht über ihre gesamte Fläche eben ausgebildet, sondern allenfalls flächenabschnittsweise eben, und/oder gekrümmt. Zweckmäßig ist hierbei, wenn nur eine der beiden Hauptflächen eine Leiterplatte umfasst, da in diesem Fall die jeweils andere Hauptfläche zusammen mit den Seitenflächen des Gehäuses kostengünstig einstückig herstellbar ist, beispielsweise in einem Spritzgussverfahren oder durch Tiefziehen. Die Leiterplatte kann dabei zur Kontaktierung der Mikrofoneinheit, also insbesondere zur Ausgabe eines in der Mikrofoneinheit erzeugten Audiosignals, verwendet werden, sowie zur Kontaktierung von innerhalb des Gehäuses angeordneten elektronischen Komponenten.

Als weiter vorteilhaft erweist es sich, wenn die Mikrofoneinheit zur Erzeugung eines elektrischen Signals aus einem Umgebungsschall ein mikro-elektro-mechanisches System (MEMS) aufweist. Mikrofone, welche zur Signalerzeugung ein MEMS verwenden, lassen sich aufgrund der geringen Dimensionen des MEMS besonders kompakt konstruieren. Aufgrund seines filigranen Aufbaus ist ein MEMS jedoch in besonderem Maße vor Umwelteinflüssen sowie vor nicht vorgesehener mechanischer Einwirkung zu schützen. Die Anordnung innerhalb des Gehäuses sowie vorzugsweise das elektrische Kontaktieren mit einer an einer der beiden Hauptflächen angeordneten Leiterplatte, beispielsweise durch Verlöten, ist hierbei besonders vorteilhaft. Durch die vorgeschlagene konvexe Einbuchtung der ersten Hauptfläche des Gehäuses lassen sich die erwünschten Platzvorteile, wie sie bei einem Einsatz eines MEMS-Mikrofones üblicherweise erzielt werden sollen, nochmals verbessern.

Bevorzugt ist innerhalb des Gehäuses eine Anzahl an Elektronikkomponenten betreffend die Vorverarbeitung eines Mikrofonsignals angeordnet. Insbesondere weist hierbei wenigstens eine der beiden Hauptflächen eine Leiterplatte auf, an welcher die Elektronikkomponenten kontaktiert sind. Das Mikrofonsignal wird hierbei bevorzugt durch wenigstens eine signalerzeugende Komponente generiert, welche im Innenraum angeordnet ist, wobei wenigstens eine der signalerzeugenden Komponenten bevorzugt mit einer Leiterplatte kontaktiert ist, welche an einer der beiden Hauptflächen angeordnet ist. Das Mikrofonsignal ist hierbei generell als das primäre elektrische Signal zu verstehen, welches aus den im Innenraum des Gehäuses bestehenden Schalldruck- bzw. Luftdruck-Unterschieden durch eine signalerzeugende Komponente unmittelbar generiert wird. Dies kann beispielsweise über ein MEMS erfolgen. Da nicht zuletzt infolge der geringen Dimensionierung die Amplitude des Mikrofonsignals sehr gering ist, bedarf es typischerweise für eine Nutzung des Mikrofonsignals außerhalb der Mikrofoneinheit im Rahmen der Anwendung in einer übergeordneten Vorrichtung, wie beispielsweise in einem Hörgerät, einer oftmals nicht unerheblichen Vorverarbeitung des Mikrofonsignals, beispielsweise durch eine Verstärkung und/oder eine Kompression der Signaldynamik. Hierbei ist es von Vorteil, die zur Vorverarbeitung verwendeten Elektronikkomponenten mit den eigentlichen signalerzeugenden Komponenten in der Mikrofoneinheit zusammen zu fassen, so dass die Mikrofoneinheit ein im Rahmen der übergeordneten Vorrichtung weiterverarbeitungsfähiges Audiosignal ausgibt. Durch die Anordnung der Elektronikkomponenten innerhalb des den Resonanzraum umfassenden Gehäuses sind diese vor äußeren Einflüssen geschützt.

Nachfolgend wird ein Ausführungsbeispiel der Erfindung anhand von Zeichnungen näher erläutert. Hierbei zeigen jeweils schematisch:
- Fig. 1: in einer Draufsicht ein Hörgerät mit einer Batterieeinheit und einer Mikrofoneinheit nach Stand der Technik,
- Fig. 2: in einer Draufsicht ein Hörgerät mit einer Batterie und einer Mikrofoneinheit, deren Hauptflächen entlang der Batterie gekrümmt sind,
- Fig. 3: in einer Schnittdarstellung ein Hörgerät mit alternativen Ausgestaltung einer gekrümmten Mikrofoneinheit,
- Fig. 4: in einer Schrägansicht die Mikrofoneinheit nach Fig. 3, und
- Fig. 5: in einer Längsschnittdarstellung die Mikrofoneinheit nach Fig. 3.

Einander entsprechende Teile und Größen sind in allen Figuren jeweils mit gleichen Bezugszeichen versehen.

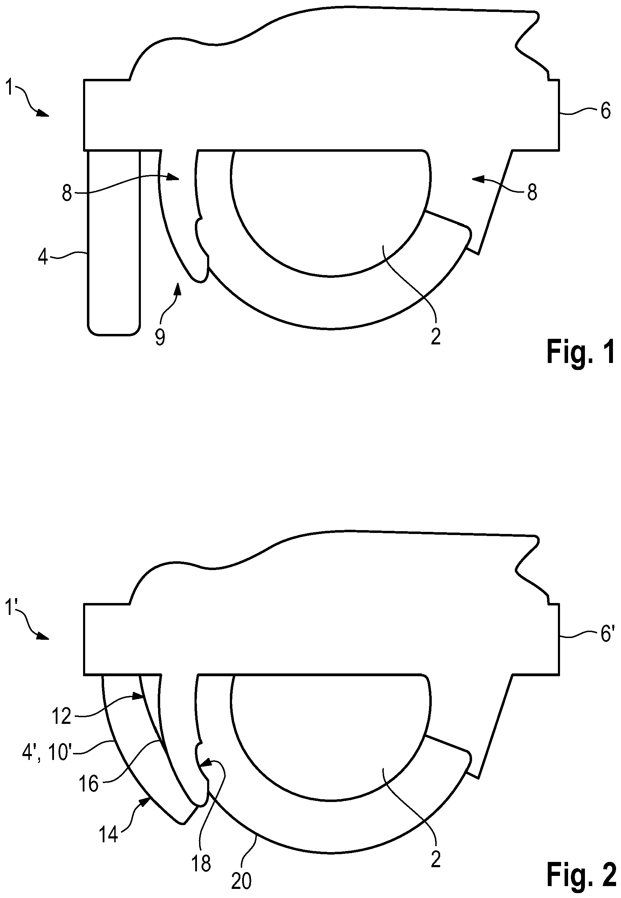

In Fig. 1 ist schematisch in einer Draufsicht ein Hörgerät 1 dargestellt, welches eine Batterie 2 und eine Mikrofoneinheit 4 gemäß Stand der Technik umfasst. Das Hörgerät 1 umfasst hierbei ein Außengehäuse 6, welches zur besseren Anschaulichkeit nur teilweise eingezeichnet ist. In das Außengehäuse 6 sind Klammern 8 zur Befestigung der Batterie 2 eingearbeitet. Im Außengehäuse 6 ist weiter die Mikrofoneinheit 4 angeordnet, welche im Betrieb des Hörgerätes 1 aus einem Umgebungsschall ein Mikrofonsignal erzeugt, welches im Hörgerät 1 benutzerspezifisch weiterverarbeitet wird. Infolge der zylindrischen Form der Batterie 2 kann die Mikrofoneinheit 4 nicht beliebig kompakt an die Batterie 2 angebaut werden, wodurch das Außengehäuse 6 größer wird, und im Innenraum des Hörgerätes 1 schwer ausnutzbare Leerräume 9 gebildet werden. Auch eine tangential zur Batterie 2 verkippte Anordnung der Mikrofoneinheit 4 würde hieran im Wesentlichen nicht viel ändern, und nur für einen durch die Verkippung und hiermit erschwerte Befestigung der Mikrofoneinheit 4 erhöhten Konstruktionsaufwand führen.

In Fig. 2 ist schematisch in einer Draufsicht ein Hörgerät 1' mit einer Batterie 2 und einer Mikrofoneinheit 4' dargestellt, welche teilweise an die Form der Batterie 2 angepasst ist. Erneut ist zur besseren Anschaulichkeit nur ein Teil des Außengehäuses 6' des Hörgerätes 1' gezeigt. Die Mikrofoneinheit 4' weist ein Gehäuse 10' mit einer ersten Hauptfläche 12 und einer der ersten Hauptfläche 12 gegenüber liegenden zweiten Hauptfläche 14 auf, wobei die erste Hauptfläche 12 konkav zum Inneren der Mikrofoneinheit 4' hin eingebuchtet ist, und die zweite Hauptfläche 14 konvex nach außen ausgebuchtet ist. In die so ausgebildete konkave Einbuchtung 16 der ersten Hauptfläche kann nun die Batterie 2 derart eingreifen, dass die Mikrofoneinheit 4' im Bereich der Klammer 8 entlang eines Abschnittes 18 der Mantelfläche 20 der Batterie 2 angeordnet werden kann.

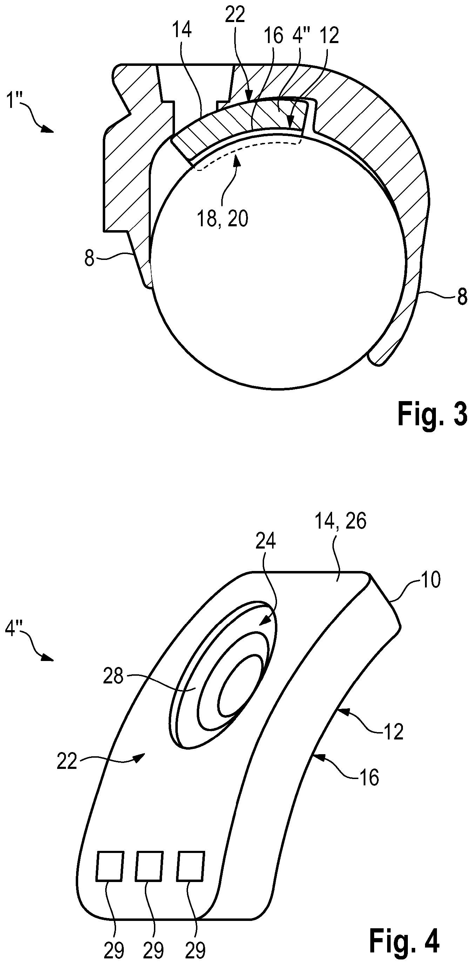

In Fig. 3 ist schematisch in einer Schnittdarstellung ein Hörgerät 1" mit einer zur in Figur 2 dargestellten Ausgestaltung alternativen Variante einer Mikrofoneinheit 4" gezeigt. Hier wird die Mikrofoneinheit 4" nicht im Bereich einer der Klammern 8, sondern direkt an der Batterie 2 angeordnet, wobei durch die konkave Einbuchtung 16 der ersten Hauptfläche 12 der Mikrofoneinheit 4" letztere für den Abschnitt 18 entlang der Mantelfläche 20 verläuft. Die Krümmung der konkaven Einbuchtung 16 ist dabei an den Radius der Batterie 2 angepasst. Die zweite Hauptfläche 14 der Mikrofoneinheit 4" weist eine der konkaven Einbuchtung 16 der ersten Hauptfläche 12 entsprechende konvexe Ausbuchtung 22 auf, welche ebenfalls an den Radius der Batterie 2 angepasst ist.

In Fig. 4 ist in einer Schrägansicht die Mikrofoneinheit 4" nach Fig. 3 dargestellt. Die Mikrofoneinheit 4" wird umschlossen von einem Gehäuse 10 mit einer ersten Hauptfläche 12 und einer der ersten Hauptfläche 12 gegenüber liegenden zweiten Hauptfläche 14. Die erste Hauptfläche 12 bildet zum des vom Gehäuse 10 umschlossenen Innenraumes hin eine konkave Einbuchtung 16 aus, die zweite Hauptfläche 14 bildet eine der konkaven Einbuchtung 16 entsprechende konvexe Ausbuchtung 22 aus. In der zweiten Hauptfläche 14 ist eine Schalleintrittsöffnung 24 eingebracht, durch welche ein Umgebungsschall in den vom Gehäuse 10 umschlossenen Innenraum gelangen kann, wo aus dem Umgebungsschall durch in Fig. 4 nicht näher dargestellte signalerzeugende Komponenten ein elektrisches Signal erzeugt wird. Die zweite Hauptfläche 14 wird hierbei gebildet durch eine Leiterplatte 26, welche mit der Schalleintrittsöffnung 24 versehen ist. Zur besseren Schallführung in den Innenraum der Mikrofoneinheit 4" und zur Vermeidung von Beugungen und Interferenzen ist an der Schalleintrittsöffnung 24 zum Innenraum hin ein Schalltrichter 28 auf der Leiterplatte 26 angeordnet. Weiter sind an der Leiterplatte 26 Kontaktelektroden 29 angeordnet, über welche die Mikrofoneinheit 10 an das Hörgerät 1" ein Mikrofonsignal ausgibt, sowie ggf. zur Leistungsversorgung aktiver Komponenten in der Mikrofoneinheit 10.

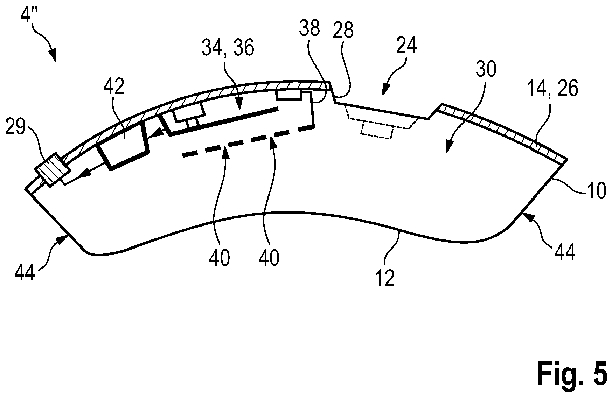

In Fig. 5 ist in einer Längsschnittdarstellung die Mikrofoneinheit 4" nach Fig. 3 gezeigt. Das Gehäuse 10 umschließt einen Innenraum 30. Durch die Schalleintrittsöffnung 24 kann entlang des auf der die zweite Hauptfläche 14 bildenden Leiterplatte 26 angeordneten Schalltrichters 28 ein Umgebungsschall in den Innenraum 30 geführt werden. Der Innenraum 30 dient dabei als Resonanzraum für den Umgebungsschall. Mit der Leiterplatte 26 verlötet ist ein MEMS-Mikrofon 34, welches eine MEMS-Membran 36 umfasst, die zusammen mit einer auf der Leiterplatte 26 verlöteten Elektrode 38 dem Prinzip nach ein Kondensatormikrofon bildet. Zur besseren Schalldurchlässigkeit hinsichtlich des Resonanzraumes ist die Elektrode 38 mit Schalllöchern 40 versehen. Das am MEMS-Mikrofon 34 erzeugte elektrische Signal wird nun einer Vorstufe 42 zugeführt, welche das elektrische Signal insbesondere mittels eines Vorverstärkers, eines Dynamik-Kompressors und eines A-D-Wandlers vorverarbeitet, und das vorverarbeitete Signal über die Kontaktelektroden 29 dem Hörgerät zur Weiterverarbeitung bereitstellt. Die konkav eingebuchtete erste Hauptfläche 12 kann hierbei zusammen mit den Seitenflächen 44 des Gehäuses 10 in einem gemeinsamen Fertigungsprozess, beispielsweise durch Spritzgießen oder Tiefenziehen, hergestellt werden, was die Produktion vereinfacht und Kosten spart.

Obwohl die Erfindung im Detail durch das bevorzugte Ausführungsbeispiel näher illustriert und beschrieben wurde, ist die Erfindung nicht durch dieses Ausführungsbeispiel eingeschränkt. Andere Variationen können vom Fachmann hieraus abgeleitet werden, ohne den Schutzumfang der Erfindung zu verlassen.

### Bezugszeichenliste

- 1: Hörgerät
- 1', 1": Hörgerät
- 2: Batterie
- 4: Mikrofoneinheit (nach Stand der Technik)
- 4', 4": Mikrofoneinheit
- 6: Außengehäuse
- 6', 6": Außengehäuse
- 8: Klammer
- 9: Leerräume
- 10: Gehäuse
- 12: erste Hauptfläche
- 14: zweite Hauptfläche
- 16: konkave Einbuchtung
- 18: Abschnitt
- 20: Mantelfläche
- 22: konvexe Ausbuchtung
- 24: Schalleintrittsöffnung
- 26: Leiterplatte
- 28: Schalltrichter
- 29: Kontaktelektrode
- 30: Innenraum
- 34: MEMS-Mikrofon
- 36: MEMS-Membran
- 38: Elektrode
- 40: Schalllöcher
- 42: Vorstufe
- 44: Seitenflächen

## Patentansprüche

1. Hörgerät (1'), umfassend eine im Wesentlichen zylinderförmige Batterie (2) und eine Mikrofoneinheit (4', 4") mit einem Gehäuse (10), welches
- eine erste Hauptfläche (12) und eine zweite Hauptfläche (14) aufweist, die einander gegenüberliegen, und
- einen Innenraum umschließt, der einen Resonanzraum umfasst,
**dadurch gekennzeichnet,**
**dass** die erste Hauptfläche (12) eine konkave Einbuchtung (16) zum Innenraum (30) hin aufweist, und
**dass** die konkave Einbuchtung (16) in der ersten Hauptfläche (12) der Mikrofoneinheit (4', 4") derart an den Radius der Batterie (2) angepasst ist, dass die Mikrofoneinheit (4', 4") entlang eines Abschnitts (18) der Mantelfläche (20) der Batterie (2) angeordnet ist.

2. Hörgerät (1') nach Anspruch 1,
wobei die konkave Einbuchtung (16) der Mikrofoneinheit (4', 4") zum Innenraum (30) hin sich über die ganze Länge der ersten Hauptfläche (12) erstreckt.

3. Hörgerät (1') nach Anspruch 1 oder Anspruch 2,
wobei die zweite Hauptfläche (14) der Mikrofoneinheit (4', 4") eine konvexe Ausbuchtung (22) aufweist.

4. Hörgerät (1') nach einem der vorhergehenden Ansprüche,
wobei die zweite Hauptfläche (14) der Mikrofoneinheit (4', 4") eine Anzahl an Schalleintrittsöffnungen (24) umfasst.

5. Hörgerät (1') nach einem der vorhergehenden Ansprüche,
wobei die erste Hauptfläche (12) und/oder zweite Hauptfläche (14) der Mikrofoneinheit (4', 4") eine Leiterplatte (26) umfasst.

6. Hörgerät (1') nach einem der vorhergehenden Ansprüche,
wobei die Mikrofoneinheit (4', 4") zur Erzeugung eines Mikrofonsignals aus einem Umgebungsschall ein Mikro-elektro-mechanisches System (34, 36) aufweist.

7. Hörgerät (1') nach einem der vorhergehenden Ansprüche,
wobei innerhalb des Gehäuses (10) der Mikrofoneinheit (4', 4") eine Anzahl an Elektronikkomponenten (42) betreffend die Vorverarbeitung eines Mikrofonsignals angeordnet ist.

## Claims

1. Hearing device (1') comprising a substantially cylindrical battery (2) and a microphone unit (4', 4'') having a housing (10) that
- has a first main surface (12) and a second main surface (14), which are opposite one another, and
- encloses an interior that comprises a resonance chamber,
**characterized**
**in that** the first main surface (12) has a concave recess (16) towards the interior (30), and
**in that** the concave recess (16) in the first main surface (12) of the microphone unit (4', 4'') is matched to the radius of the battery (2) such that the microphone unit (4', 4'') is arranged along a section (18) of the lateral surface (20) of the battery (2).

2. Hearing device (1') according to Claim 1,
wherein the concave recess (16) of the microphone unit (4', 4'') towards the interior (30) extends over the entire length of the first main surface (12) .

3. Hearing device (1') according to Claim 1 or Claim 2,
wherein the second main surface (14) of the microphone unit (4', 4'') comprises a convex bulge (22) .

4. Hearing device (1') according to one of the preceding claims,
wherein the second main surface (14) of the microphone unit (4', 4'') comprises a number of sound inlet apertures (24).

5. Hearing device (1') according to one of the preceding claims,
wherein the first main surface (12) and/or second main surface (14) of the microphone unit (4', 4'') comprises a circuit board (26).

6. Hearing device (1') according to one of the preceding claims,
wherein the microphone unit (4', 4'') comprises a microelectromechanical system (34, 36) for generating a microphone signal from an ambient sound.

7. Hearing device (1') according to one of the preceding claims,
wherein a number of electronic components (42) for pre-processing a microphone signal are arranged inside the housing (10) of the microphone unit (4', 4'').

## Revendications

1. Appareil auditif (1'), comprenant une pile/batterie (2) de forme sensiblement cylindrique et une unité de microphone (4', 4'') munie d'un boîtier (10), laquelle
- possède une première surface principale (12) et une deuxième surface principale (14) qui sont face à face l'une de l'autre et
- entoure un espace intérieur qui comporte un espace de résonance,
**caractérisé en ce**
**que** la première surface principale (12) possède un renfoncement concave (16) vers l'espace intérieur (30) et
**que** le renfoncement concave (16) dans la première surface principale (12) de l'unité de microphone (4', 4'') est adapté au rayon de la pile/batterie (2) de telle sorte que l'unité de microphone (4', 4'') est disposée le long d'une portion (18) de l'enveloppe (20) de la pile/batterie (2).

2. Appareil auditif (1') selon la revendication 1, le renfoncement concave (16) de l'unité de microphone (4', 4'') s'étendant vers l'espace intérieur (30) sur toute la longueur de la première surface principale (12) .

3. Appareil auditif (1') selon la revendication 1 ou la revendication 2, la deuxième surface principale (14) de l'unité de microphone (4', 4'') possédant un renfoncement convexe (22).

4. Appareil auditif (1') selon l'une des revendications précédentes, la deuxième surface principale (14) de l'unité de microphone (4', 4'') comportant un certain nombre d'ouvertures d'entrée de son (24).

5. Appareil auditif (1') selon l'une des revendications précédentes, la première surface principale (12) et/ou la deuxième surface principale (14) de l'unité de microphone (4', 4'') comportant un circuit imprimé (26).

6. Appareil auditif (1') selon l'une des revendications précédentes, l'unité de microphone (4', 4") possédant un système électromécanique de microphone (34, 36) destiné à générer un signal de microphone à partir d'un bruit environnant.

7. Appareil auditif (1') selon l'une des revendications précédentes, un certain nombre de composants électroniques (42) concernant le prétraitement d'un signal de microphone étant disposés à l'intérieur du boîtier (10) de l'unité de microphone (4' , 4'').
